# FASCICULE DE BREVET EUROPEEN

(11) **EP 0 359 675 B1**
(45) Date de publication et mention de la délivrance du brevet: **03.03.1993**
(21) Numéro de dépôt: 89420296.9
(22) Date de dépôt: 09.08.1989
(51) Int. Cl.: H03K 17/13

(54) **Dispositif de coupure statique pour circuit électrique à moyenne tension**
Statische Unterbrechervorrichtung für elektrische Mittelspannungsschaltung
Static breaker device for a middle-range voltage electrical circuit

(30) Priorité: 02.09.1988 FR 8811617
(43) Date de publication de la demande: 21.03.1990
(73) Titulaire: MERLIN GERIN, F-38240 Meylan (FR)
(72) Inventeur: Bettega, Eric, F-38050 Grenoble Cédex (FR); Vaillant, Frédéric, F-38050 Grenoble Cédex (FR)
(74) Mandataire: Hecké, Gérard

(56) Documents cités:
- EP-A- 0 108 391
- EP-A- 0 155 076
- CA-A- 1 162 977
- FR-A- 2 097 618
- GB-A- 1 253 885
- GB-A- 1 586 960
- GB-A- 2 062 372
- US-A- 3 611 043
- AEG-TELEFUNKEN, vol. 50, no. 1/2, 1977, pages 22-31; W. LUKANZ: "Halbleiterschalter und -steller für den Mittelspannungsbereich"
- PROCEEDINGS IEE, vol. 126, no. 1, janvier 1979, pages 75-76, Stevenage, GB; M. KHALIFA et al.: "Solid-state A.C. circuit breaker"

## Description

L'invention est relative à un dispositif de coupure statique, notamment un contacteur, un interrupteur ou un disjoncteur inséré dans les conducteurs de ligne d'un réseau électrique alternatif triphasé à phases, et comportant:
- au moins un module élémentaire disposé dans chaque conducteur de ligne et comprenant un montage antiparallèle de deux thyristors de puissance, et un dispositif écrêteur de tension branché en parallèle aux bornes des thyristors,
- un circuit individuel de commande associé à la gâchette de chaque thyristor pour assurer le passage de l'état bloqué vers l'état conducteur, et vice-versa,
- et une unité de commande centralisée destinée à gérer les signaux de commande de fermeture et d'ouverture envoyés aux différents circuits individuels de commande.

Un dispositif très semblable est décrit dans le document GB-A- 1.253.885, qui décrit un relais statique synchronisé adapté pour un circuit alternatif à basse tension.

Dans un réseau à moyenne tension le dispositif de coupure statique peut être un contacteur ou un disjoncteur triphasé fonctionnant à des tensions jusqu'à 7,2 kV, et ayant une charge inductive. Un premier problème posé par ce type d'appareillage statique est le fort appel de courant possible intervenant lors de l'enclenchement sans synchronisation du contacteur par commutation des thyristors de l'état bloqué vers l'état conducteur. Un deuxième problème intervient lors de la coupure triphasée d'un contacteur ou disjoncteur statique sur charge selfique. La première phase interrompue voit sa tension transitoire de rétablissement de valeur moyenne sensiblement supérieure aux deux autres phases. Etant donné que la première interruption peut intervenir sur l'une quelconque des trois phases, il faut surdimensionner la totalité des thyristors pour satisfaire à la tenue en tension. Il en résulte des problèmes d'encombrement et de coût.

L'objet de l'invention consiste à synchroniser l'enclenchement du dispositif de coupure statique inséré dans un réseau triphasé pour limiter les di/dt à la fermeture, et à éviter le surdimensionnement d'une partie des thyristors dû à la tension transitoire de rétablissement.

Le dispositif de coupure statique selon l'invention est caractérisé en ce qu'un indicateur de polarité coopère avec le module pour indiquer le sens de la tension alternative présente aux bornes des thyristors lorsque ces derniers se trouvent dans l'état bloqué, et que l'unité de commande centralisée comporte:
- un premier circuit logique d'enclenchement sensible aux informations en provenance de l'indicateur de polarité de manière à autoriser l'émission d'un signal de commande de fermeture vers le circuit individuel du thyristor dont la tension anode-cathode devient négative,
- et un deuxième circuit logique d'ouverture contrôle par un détecteur de passage à zéro du courant de ligne circulant dans la phase précédant la première phase à ouvrir dans l'ordre de succession des phases.

La synchronisation à l'enclenchement est obtenue grâce à un indicateur de polarité qui indique le sens de la tension alternative aux bornes des thyristors bloqués, à un premier circuit logique d'enclenchement, autorisant l'émission d'un signal de commande de fermeture. La commande d'allumage de chaque thyristor est exclusivement enclenchée lorsque ce dernier est en inverse. Le courant d'appel est alors nul, ce qui évite les di/dt à la fermeture.

La présence du deuxième circuit logique d'ouverture permet de choisir avantageusement la chronologie d'ouverture des thyristors en régime nominal, en interrompant toujours la même phase en premier. Les thyristors de cette phase seront les seuls à être adaptés pour une tenue en tension sensiblement supérieure à celle nécessaire pour les deux autres phases.

L'indicateur de polarité est branché en parallèle aux bornes du module, et comporte un circuit optoélectronique de discrimination des alternances positive et négative de la tension, coopérant avec une fibre optique de transmission reliée au premier circuit logique d'enclenchement de l'unité de commande centralisée. L'indicateur de polarité est composé d'une résistance de forte valeur en série avec un montage tête-bêche d'une diode électroluminescente et d'une diode.

Chaque conducteur de ligne comporte un capteur de courant associé à un circuit à seuil connecté à l'entrée du deuxième circuit logique d'ouverture.

L'utilisation d'indicateurs optoélectroniques à fibres optiques et de capteurs de courant à tore amagnétique permet d'assurer un bon isolement entre les blocs de commande au potentiel proche de la masse, et les blocs de puissance au potentiel de la moyenne tension.

D'autres avantages et caractéristiques ressortiront plus clairement de la description qui va suivre d'un mode de réalisation de l'invention donné à titre d'exemple non limitatif et représenté aux dessins annexés dans lesquels:
- la figure 1 est un schéma électrique d'un contacteur statique monophasé équipé du circuit de commande selon l'invention;
- la figure 2 montre le schéma d'un contacteur statique triphasé selon l'invention;
- la figure 3 représente le schéma d'un indicateur de polarité utilisé dans les modules à thyristors;
- les figures 4 et 5 montrent respectivement les circuits logiques d'enclenchement et d'ouverture de l'unité de commande centralisée;
- la figure 6 montre le chronogramme de fonctionnement d'un module à thyristors du contacteur selon la figure 1.

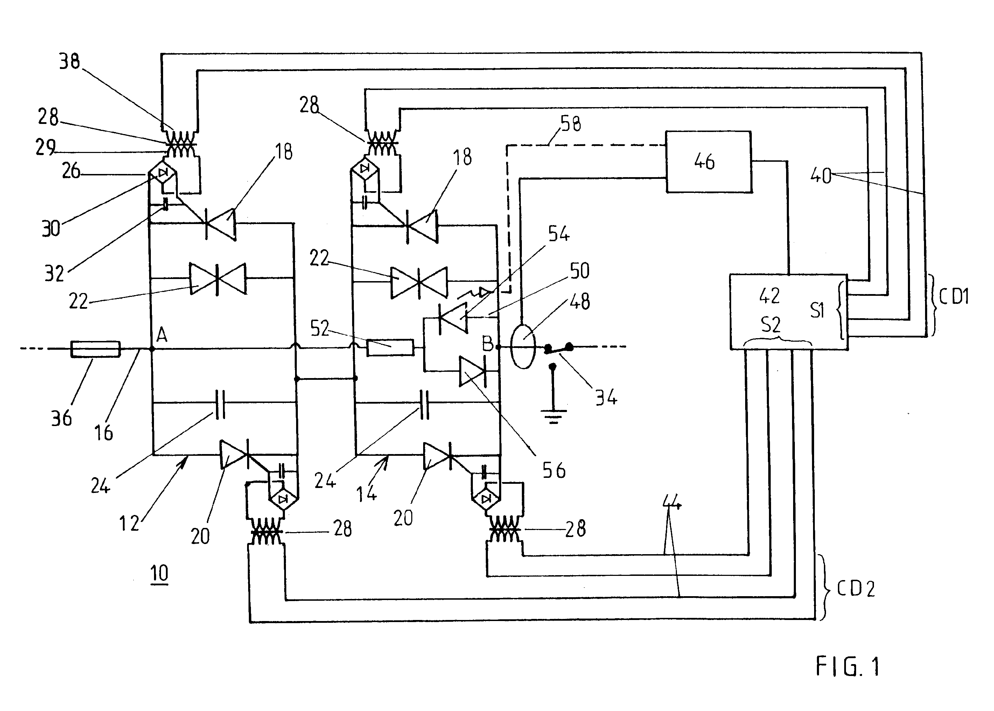

Sur la figure 1, un contacteur statique 10 monophasé à thyristors comporte une pluralité de modules 12,14 élémentaires identiques connectés en série dans un conducteur de ligne 16 appartenant à un circuit électrique alternatif. Chaque module 12,14 est du type décrit dans le brevet français FR-A-2630597, et comporte deux thyristors 18,20 de puissance branchés en parallèle tête-bêche. Un limiteur de surtension 22 est connecté en parallèle sur les thyristors 18,20 de chaque module 12,14 pour écrêter les surtensions transitoires. Un condensateur 24 à haute tension est également branché en parallèle aux bornes des thyristors 18,20 pour limiter les fronts de montée de la tension à des valeurs admissibles pour les thyristors.

Le circuit gâchette-cathode de chaque thyristor 18,20 est associé à un circuit individuel de commande d'allumage 26 ayant un transformateur 28 à haut pouvoir d'isolement. La tension dans le circuit secondaire 29 du transformateur 28 est redressée par un pont redresseur 30 à diodes, et lissée par un condensateur de filtrage 32. Chaque thyristor 18,20 est piloté par un courant continu et non pas par impulsions.

Le nombre de modules 12,14 élémentaires en série dépend bien entendu de la valeur de la tension nominale du réseau. Un seul module à thyristors serait suffisant pour une tension de 3,3 kV, et deux modules 12,14 pour une tension de 6,6 kV (cas de la figure 1).

Un sectionneur 34 est inséré en série dans le conducteur 16 en aval du module 14. En amont du module 12 se trouve un limiteur de courant 36 formé dans le cas du contacteur 10 par un coupe-circuit à fusible à haute tension. Si le fusible est remplacé par une bobine d'inductance capable de limiter les courants de court-circuit à des valeurs acceptables pour les thyristors, l'ensemble constitue un disjoncteur.

L'enroulement primaire 38 de chacun des deux transformateurs 28 supérieurs de commande des thyristors 18 est relié par une première liaison électrique 40 à des connecteurs S1 d'une source d'alimentation 42 renfermant un générateur de courant alternatif à haute fréquence. Une deuxième liaison électrique 44 relie d'une manière analogue les enroulements primaires 38 des deux transformateurs 28 inférieurs de commande des thyristors 20 à des connecteurs S2 de la source 42.

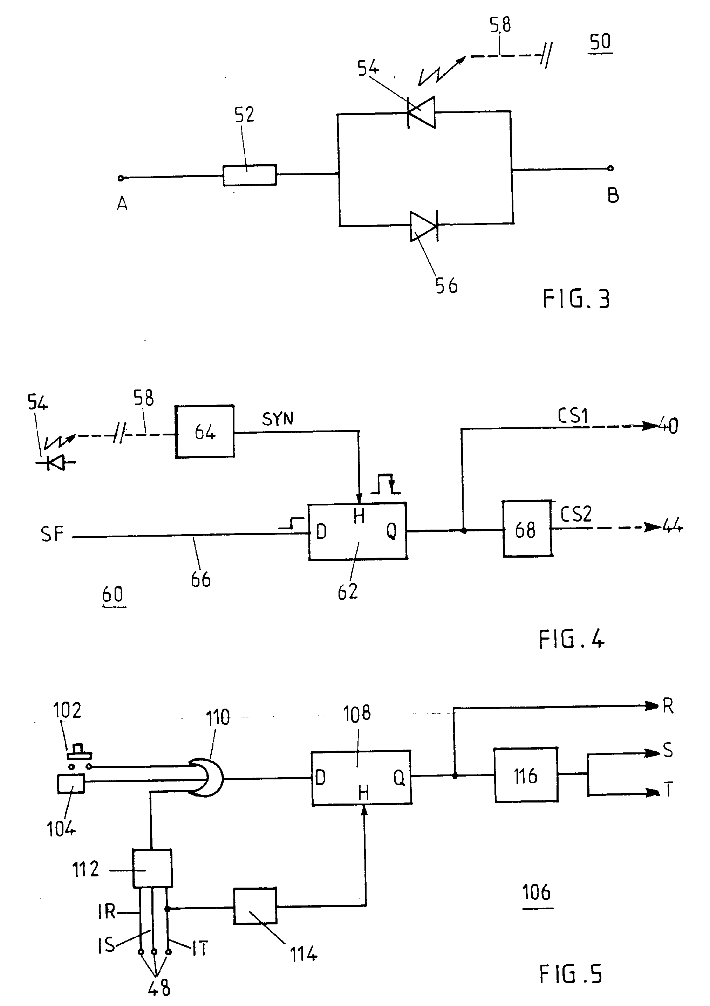

La source d'alimentation 42 est pilotée par une unité de commande centralisée 46 recevant des informations de mesure en provenance d'un capteur de courant 48 et d'un indicateur de polarité 50 de la tension alternative aux bornes des modules 12,14. Le capteur de courant 48, agencé entre le module 14 et le sectionneur 34, comporte avantageusement un circuit à tore amagnétique traversé par le conducteur de ligne 16 et comprenant un enroulement de mesure délivrant en permanence un signal de mesure proportionnel à la dérivée du courant circulant dans le conducteur de ligne 16. L'indicateur de polarité 50 de la tension (montré en détail à la figure 3) est branché en parallèle entre les points A et B des modules 12,14, et est composé d'une résistance 52 de valeur élevée, placée en série avec un circuit de discrimination des alternances positive et négative comprenant une diode électroluminescente 54 et une diode 56 montées en tête-bêche.

Lorsque le contacteur 10 est passant, les thyristors 18,20 des deux modules 12,14 se trouvent dans l'état de conduction et la tension aux bornes A et B de l'indicateur 50 est quasi-nulle. La diode électroluminescente 54 reste éteinte en permanence.

Dans l'état ouvert du contacteur 10 suite au blocage des thyristors 18,20, une tension alternative UAB est présente entre les bornes A et B. Lorsque la tension UAB est positive, un courant passe dans la diode 56, alors que la diode électroluminescente 54 reste éteinte. Lorsque la tension UAB est négative, le courant passe dans la diode électroluminescente 54 qui s'allume. La valeur de la résistance 52 limite le courant dans l'indicateur 50 à une valeur donnée, par exemple 1 mA, pour éviter l'échauffement de la résistance 52, et pour être négligeable par rapport au courant de fuite des thyristors 18,20.

La diode électroluminescente 54 de l'indicateur 50 est du type émetteur coopérant avec une fibre optique 58 pour la transmission des informations du sens de la tension aux bornes A et B vers l'unité de commande 46. Ces informations seront exploitées pour le contrôle de la phase d'enclenchement du contacteur 10 faisant passer les thyristors 18,20 de l'état bloqué vers l'état conducteur.

L'unité de commande 46 est dotée à cet effet d'un premier circuit logique 60 d'enclenchement (voir figure 4) comportant à titre d'exemple, une bascule D 62 dont l'entrée H est reliée à un circuit convertisseur 64 à récepteur optoélectronique transformant le signal lumineux transmis par la fibre optique 58 en un signal électrique de forme carrée utilisé comme signal de synchronisation. A l'entrée D, peut être appliqué par l'intermédiaire d'un conducteur 66, un ordre de fermeture SF, lequel est susceptible d'être transféré à la sortie Q de la bascule 62 au front descendant du signal d'horloge ou de synchronisation présent à l'entrée H. La sortie Q est reliée à un circuit temporisateur 68 pour piloter l'excitation des thyristors 20 inférieurs avec un certain retard par rapport aux thyristors 18 supérieurs.

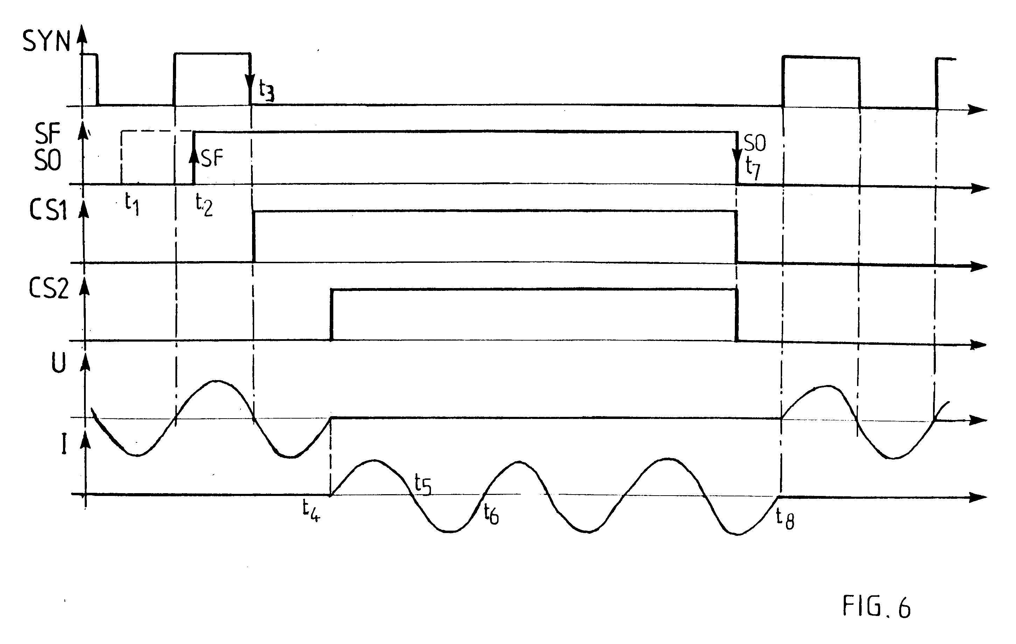

La bascule D 62 pourrait bien entendu être remplacée pour tout autre circuit logique sensible au signal de synchronisation SYN. Le fonctionnement du contacteur 10 monophasé de la figure 1 est illustré au chronogramme de la figure 6 montrant successivement le signal de synchronisation SYN issu du circuit convertisseur 64, le signal de commande SF et SO représentant l'ordre de fermeture et d'ouverture du contacteur, le premier signal de commande CS1 d'excitation des thyristors 18, le deuxième signal de commande CS2 d'excitation des thyristors 20, la tension U aux bornes des modules 12,14, et le courant I traversant les thyristors des modules.

Pour la phase d'enclenchement, l'ordre de fermeture SF est aléatoire (voir instants t1 ou t2) et le signal de synchronisation SYN est engendré lors de l'alternance positive de la tension U alternative aux bornes des thyristors 18,20 bloqués. En présence de l'ordre de fermeture SF à l'instant t3 du front descendant du signal de synchronisation SYN, la bascule 62 du premier circuit logique 60 d'enclenchement détecte le passage en inverse de la tension aux bornes des thyristors supérieurs 18, et génère simultanément le premier signal de commande CS1 permettant l'émission par la liaison 40 de la source d'alimentation 42 d'un courant d'excitation à haute fréquence dans les enroulements primaires 38 des transformateurs 28 affectés aux deux thyristors 18 supérieurs. Au prochain passage à zéro de la tension U à l'instant t4, les deux thyristors 18 commutent naturellement vers l'état conducteur (voir alternance positive du courant I entre les instants t4 et t5). Le deuxième signal de commande CS2 est délivré par le circuit temporisateur 68 à l'instant t4 de manière à assurer la commutation naturelle des deux thyristors 20 inférieurs vers l'état conducteur à l'instant t5 (voir alternance négative du courant I pendant les instants t5 et t6). Le passage en inverse de la tension aux bornes des thyristors signifie que la tension anode-cathode devient négative au passage à zéro.

Lorsque le contacteur 10 est passant, le courant principal I transite par les thyristors 18,20. Ces derniers présentent une légère chute de potentiel à leurs bornes et de ce fait dissipent une certaine quantité de chaleur. Un système de dissipation thermique est associé à chaque thyristor. Dans les faibles gammes de courant, la dissipation en convection naturelle sera suffisante. Dans les gammes plus importantes, la dissipation devra être assurée par convection forcée.

La passage du contacteur 10 de l'état conducteur vers l'état bloqué intervient par interruption simultanée du courant d'excitation dans les quatre primaires des transformateurs 28 des modules 12,14. La phase d'ouverture est explicitée par le chronogramme de la figure 6 dans lequel l'ordre d'interruption SO intervient à l'instant t7. Au même moment, les deux signaux de commande CS1 et CS2 inhibent les dispositifs de commande 26 des thyristors 18,20. Au prochain passage à zéro du courant I à l'instant t8, les thyristors 18,20 se bloquent, avec rétablissement de la tension alternative U, et du signal de synchronisation SYN. Dans l'état ouvert du contacteur 10 les gâchettes des thyristors 18,20 ne sont pas alimentées. Les thyristors 18,20 sont bloquant dans les deux sens pour des tensions inférieures à leurs tensions de latch-up. Aucun courant ne traverse les modules 12, 14, à l'exception des courants de fuites et de celui de la résistance 52 de l'indicateur 50.

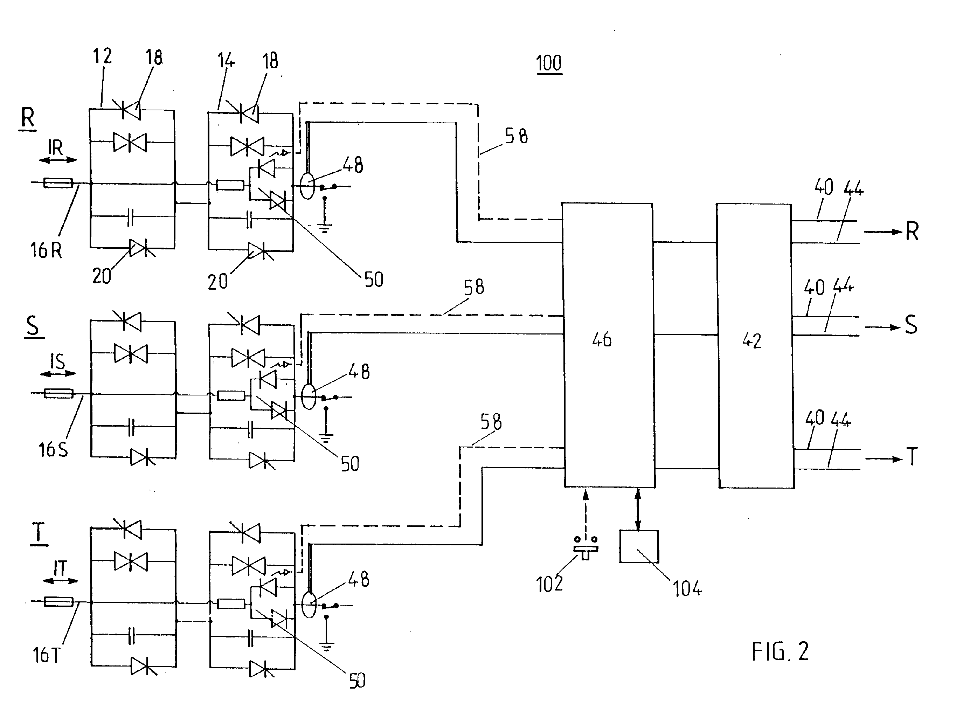

Sur la figure 2, un contacteur statique triphasé 100 pour l'alimentation d'un moteur à moyenne tension utilise, dans chaque conducteur de phase 16R, 16S, 16T du réseau triphasé, les modules 12,14 élémentaires à thyristors 18,20 tête-bêche de la figure 1, avec l'indicateur de polarité 50 et le capteur de courant 48. Les mêmes numéros de repères seront utilisés pour désigner des éléments identiques ou analogues à ceux de la figure 1. L'unité de commande 46 électronique est pilotée par trois fibres optiques 58 associées aux trois indicateurs de polarité 50 des trois phases, et par les capteurs de courant 48 qui délivrent les images des courants IR, IS, IT circulant dans les trois conducteurs 16R, 16S, 16T. La source d'alimentation 42 contrôlée par l'unité de commande 46 comporte trois séries de sorties, ayant chacune des liaisons 40,44 pour la commande d'allumage des thyristors 18,20 de chaque phase R, S, T.

L'unité de commande 46 permet de contrôler l'enclenchement des modules 12,14 des différentes phases R, S, T grâce aux informations émises par les diodes électroluminescentes 54 des indicateurs 50 sur le sens de la tension alternative présente aux bornes des thyristors 18,20. Préalablement à cette phase d'enclenchement, les informations des diodes électroluminescentes 54 servent à vérifier la présence et la chronologie des tensions sur le réseau permettant de tester si le raccordement électrique sur les trois phases est correct. En cas de branchement erroné, tous les ordres de fermeture du contacteur 100 en provenance d'un commutateur manuel 102 de commande ou d'un automate 104 sont inhibés. La séquence d'enclenchement des thyristors 18,20 s'effectue ensuite phase par phase selon le principe du chronogramme de la figure 6.

Lors d'une ouverture du contacteur 100 en régime triphasé sur charge passive, la première phase interrompue voit pendant un court instant une tension transitoire de rétablissement de valeur moyenne sensiblement supérieure aux deux autres phases. Pour éviter de dimensionner la totalité des phases pour cette valeur de tension, il est intéressant de choisir la chronologie d'ouverture pour le régime nominal en interrompant toujours la même phase en premier. En supposant qu'il s'agisse de la première phase R, les thyristors 18,20, le limiteur de surtension 22 et le condensateur 24 des modules 12 et 14 insérés dans le conducteur de ligne 16R, seront adaptés pour une tenue en tension 1,5 fois supérieure à celle nécessaire pour les deux autres phases S et T. Un tel dimensionnement est valable lorsque le nombre de modules 12,14 à thyristors de la première phase est identique à ceux des autres phases. Selon une variante, les composants dans les différents modules du contacteur 100 présentent des tenues en tension identiques, mais le nombre de modules élémentaires est augmenté dans la première phase interrompue. Un tel agencement dissymétrique des trois branches du contacteur 100 permet d'éviter le surdimensionnement de deux phases dont l'ouverture intervient après celle de la première phase.

Pour ouvrir toujours la même phase en premier, l'unité de commande 46 comporte un deuxième circuit logique 106 d'ouverture (voir figure 5) ayant une bascule D108. L'entrée D de la bascule 108 est connectée à une porte logique OU 110 pilotée soit par le commutateur 102 d'ouverture manuelle, soit par l'automate 104, soit par un circuit à seuil 112 associé aux trois capteurs de courant 48. L'entrée H de la bascule 108 est contrôlée par un détecteur 114 de passage à zéro du courant dans la phase précédant la première phase à ouvrir dans l'ordre de succession des phases. Etant donné que les phases se succèdent dans l'ordre R, S, T, et que la phase R est choisie à titre d'exemple pour être celle systématiquement ouverte en premier, l'ordre effectif d'ouverture est envoyé à ladite phase R par la sortie Q de la bascule 108 après le passage à zéro du courant IT dans le conducteur de ligne 16T de la phase T.

La séquence poursuivie de blocage des thyristors 18,20 des modules 12,14 de la phase R est identique à celle montrée sur le chronogramme de la figure 6, dans laquelle le signal SO correspond à l'ordre effectif d'ouverture confirmé par la bascule 114.

Un circuit temporisateur 116 est connecté à la sortie Q de la bascule 108 pour commander le blocage des thyristors 18,20 des deux phases restantes S et T.

Au passage au zéro de courant, les thyristors 18,20 de la phase correspondante passent à l'état bloqué, étant donné l'absence de commande d'allumage dans le circuit gâchette-cathode. Le courant I s'interrompt naturellement, et la tension U se rétablit selon un régime oscillatoire amorti.

Dans le cas de l'utilisation en contacteur, les courants de court-circuit importants ne sont pas interrompus par les thyristors 18,20, mais par les coupe-circuits à fusibles 36. Le circuit à seuil 112 est adapté à tous les défauts intermédiaires, par exemple courants de démarrage trop élevés, rotor du moteur bloqué. L'ensemble constitue alors un contacteur autoprotégé.

Un dialogue est possible avec l'utilisateur par l'intermédiaire de l'unité de commande 46 pour permettre différentes configurations, par exemple réglage de la courbe de protection, sens des phases, etc... En retour, l'unité de commande 46 informe l'utilisateur à propos des différents paramètres de fonctionnement de la charge, par exemple le courant absorbé, le diagnostic des différents défauts, etc...

On remarque le rôle essentiel de l'unité de commande 46 dans la gestion des différents ordres d'enclenchement et de déclenchement du contacteur 100. Les ordres de fermeture dépendent exclusivement des informations de tension émises par les diodes électroluminescentes 54 des indicateurs 50 branchés aux bornes des modules 12,14. L'instant d'allumage des thyristors intervient lors du passage de la tension en inverse. Les ordres d'ouverture sont déterminés en fonction des informations recueillies par les capteurs de courant 48, en prenant en compte le passage à zéro du courant dans la phase précédent la première phase à ouvrir dans l'ordre de succession des phases.

L'isolement entre les blocs de commande 42,46 au potentiel proche de la masse et le bloc de puissance des différents modules 12,14 se trouvant au potentiel du réseau à moyenne tension, est assuré par les transformateurs d'isolement 28, les liaisons par fibres optiques 58 et les tores amagnétiques des capteurs de courant 48.

Selon une variante, les modules à thyristors 18,20 des contacteurs 10,100 des figures 1 et 2 sont adaptés pour un fonctionnement en disjoncteur.

## Revendications

1. Dispositif de coupure statique, notamment un contacteur, un interrupteur ou un disjoncteur inséré dans les conducteurs de ligne (16R,16S, 16T) d'un réseau électrique alternatif triphasé à phases (R, S, T), et comportant:
- au moins un module (12,14) élémentaire disposé dans chaque conducteur de ligne (16R, 16S, 16T) et comprenant un montage antiparallèle de deux thyristors (18,20) de puissance, et un dispositif écrêteur de tension (22) branché en parallèle aux bornes des thyristors (18,20),
- un circuit individuel de commande (26) associé à la gâchette de chaque thyristor (18,20) pour assurer le passage de l'état bloqué vers l'état conducteur, et vice-versa,
- et une unité de commande centralisée (46) destinée à gérer les signaux de commande (CS1, CS2) de fermeture et d'ouverture envoyés aux différents circuits individuels de commande (26),
caractérisé en ce qu'un indicateur de polarité (50) coopère avec le module (12,14), pour indiquer le sens de la tension alternative présente aux bornes des thyristors (18,20) lorsque ces derniers se trouvent dans l'état bloqué, et que l'unité de commande centralisée (46) comporte:
- un premier circuit logique (60) d'enclenchement sensible aux informations en provenance de l'indicateur de polarité (50) de manière à autoriser l'émission d'un signal de commande de fermeture vers le circuit individuel de commande (26) du thyristor (18,20) dont la tension anode-cathode devient négative.
- et un deuxième circuit logique (106) d'ouverture contrôlé par un détecteur (114) de passage à zéro du courant de ligne circulant dans la phase précédant la première phase à ouvrir dans l'ordre de succession des phases (R, S, T).

2. Dispositif de coupure statique selon la revendication 1, caractérisé en ce que l'indicateur de polarité (50) est branché en parallèle aux bornes du module (12,14), et comporte un circuit optoélectronique de discrimination des alternances positive et négative de la tension, coopérant avec une fibre optique (58) de transmission reliée au premier circuit logique (60) d'enclenchement de l'unité de commande centralisée (46).

3. Dispositif de coupure statique selon la revendication 2, caractérisé en ce que l'indicateur de polarité (50) est composé d'une résistance (52) en série avec un montage tête-bêche d'une diode électroluminescente (54) et d'une diode (56).

4. Dispositif de coupure statique selon la revendication 2 ou 3, caractérisé en ce que le premier circuit logique (60) d'enclenchement comporte un circuit convertisseur (64) transformant le signal lumineux transmis par la fibre optique (58) en un signal électrique de synchronisation (SYN) indiquant l'instant de l'inversion de la tension aux bornes du thyristor (18,20) à commuter vers l'état conducteur.

5. Dispositif de coupure statique selon la revendication 4, caractérisé en ce que le premier circuit logique (60) est doté d'une bascule (62) comprenant une entrée (H) sensible au signal de synchronisation (SYN), et une sortie (Q) destinée à piloter l'émission des premier et deuxième signaux de commande (CS1 et CS2) de fermeture des thyristors (18,20) avec une temporisation prédéterminée.

6. Dispositif de coupure statique selon la revendication 1, caractérisé en ce que dans chaque conducteur de ligne (16R, 16S, 16T) est inséré un capteur de courant (48) associé à un circuit à seuil (112) connecté à l'entrée du deuxième circuit logique (106) d'ouverture.

7. Dispositif de coupure statique selon la revendication 6, caractérisé en ce que chaque capteur de courant (48) comprend un tore amagnétique destiné à isoler le conducteur de ligne (16R, 16S,16T) correspondant de l'unité de commande centralisée (46).

8. Dispositif de coupure statique selon la revendication 6 ou 7, caractérisé en ce que le deuxième circuit logique (106) d'ouverture comporte une bascule (108) ayant une première entrée (H) reliée au détecteur (114), et une deuxième entrée (D) sensible soit à une commande d'ouverture manuelle par un commutateur (102), soit à une commande d'ouverture automatique par un automate (104) ou le circuit à seuil (112).

9. Dispositif de coupure statique selon l'une des revendications 1 à 8, caractérisé en ce qu'une pluralité de modules (12,14...) élémentaires à thyristors (18,20) sont placés en série dans chaque conducteur de ligne en fonction de la valeur de la tension nominale du réseau à moyenne tension, l'ensemble des modules étant de plus connecté en série avec un limiteur de courant (36), notamment un coupe-circuit à fusible ou une inductance, et que le circuit individuel de commande (26) de chaque thyristor (18,20) alimente en permanence le circuit gâchette-cathode de chaque thyristor (18,20) tant que ledit thyristor doit rester passant.

## Patentansprüche

1. Statische Unterbrechervorrichtung, insbesondere ein Schütz, ein Lasttrennschalter oder ein Leistungsschalter, integriert in die Phasenleiter (16R, 16S, 16T) eines Dreiphasen-Wechselstromnetzes mit den Phasen (R, S, T), bestehend aus:
- mindestens einem in jedem Phasenleiter (16R, 16S, 16T) angeordneten Hauptmodul (12, 14) mit einer Antiparallelschaltung von zwei Leistungsthyristoren (18, 20) und einem parallel zu den klemmen der Thyristoren (18, 20) geschalteten Überspannungsbegrenzer (22),
- einem mit dem Gate-Anschluß jedes Thyristors (18, 20) verbundenen individuellen Steuerkreis (26), um die Umschaltung vom Durchlaß- zum Sperrbetrieb und umgekehrt zu gewährleisten,
- und einer zentralen Steuereinheit (46) zur Verarbeitung der Schliess- und Öffnungs-Steuersignale (SC1, SC2), die an die verschiedenen individuellen Steuerkreise (26) geschickt werden.
dadurch gekennzeichnet, daß eine Polaritätsanzeige (50) mit dem Hauptmodul (12, 14) zusammenwirkt, um die Richtung der an den klemmen der Thyristoren (18, 20) im Sperrzustand anliegenden Wechselspannung anzuzeigen, und daß die zentrale Steuereinheit (46) aus folgenden Komponenten besteht:
- einer ersten Einschalt-Logikschaltung (60) zur Aufnahme der Signale der Polaritätsanzeige (50), um die Aussendung eines Schliessbefehls an den individuellen Steuerkreis (26) des Thyristors (18, 20) weiterzuleiten, dessen Anoden-kathoden-Spannung negativ wird.
- einer zweiten, Öffnungs-Logikschaltung (106), die von einem Detektor (114) des Stromnulldurchgangs in dem Phasenleiter kontrolliert wird, der gemäß dem Phasendrehsinn (R, S, T) der abzuschaltenden Phase vorausgeht.

2. Statische Unterbrechervorrichtung gemäß Anspruch 1, dadurch gekennzeichnet, daß die Polaritätsanzeige (50) parallel zu den klemmen des Hauptmoduls (12, 14) liegt und eine zur Erfassung des positiven und negativen Spannungsverlaufs dienende optoelektronische Schaltung umfaßt, die mit einem an die erste Einschalt-Logikschaltung (60) der zentralen Steuereinheit (46) angeschlossenen Lichtwellenleiter (58) zusammenwirkt.

3. Statische Unterbrechervorrichtung gemäß Anspruch 2, dadurch gekennzeichnet, daß die Polaritätsanzeige (50) aus einem Widerstand (52) und einer dazu in Reihe liegenden Antiparallelschaltung aus einer Leuchtdiode (54) und einer Diode (56) besteht.

4. Statische Unterbrechervorrichtung gemäß Anspruch 2 oder 3, dadurch gekennzeichnet, daß die erste Einschalt-Logikschaltung (60) aus einem Wandler (64) besteht, der das vom Lichtwellenleiter (58) übertragene Lichtsignal in ein elektrisches Synchronisierungssignal (SYN) umsetzt, das den Augenblick der Spannungsumkehr an den klemmen des vom Sperr- in den Durchlaßzustand umzuschaltenden Thyristors (18, 20) anzeigt.

5. Statische Unterbrechervorrichtung gemäß Anspruch 4, dadurch gekennzeichnet, daß die erste Einschalt-Logikschaltung (60) eine Kippstufe (62) umfaßt, deren Eingang (H) mit dem Synchronisierungssignal (SYN) beaufschlagt wird und über deren Ausgang (Q) der erste und zweite Steuerbefehl (CS1 und CS2) zum Einschalten der Thyristoren (18, 20) mit einer festgelegten Zeitverzögerung gesteuert wird.

6. Statische Unterbrechervorrichtung gemäß Anspruch 1, dadurch gekennzeichnet, daß in jedem Phasenleiter (16R, 16S, 16T) ein Stromwandler (48) angebracht ist, der mit einer am Eingang der zweiten Ausschalt-Logikschaltung (106) liegenden Schwellwertschaltung (112) zusammenwirkt.

7. Statische Unterbrechervorrichtung gemäß Anspruch 6, dadurch gekennzeichnet, daß jeder Stromwandler mit einen unmagnetischen Ringkern zur galvanischen Trennung des jeweiligen Phasenleiters (16R, 16S, 16T) von der zentralen Steuereinheit (46) ausgeführt ist.

8. Statische Unterbrechervorrichtung gemäß Anspruch 6 oder 7, dadurch gekennzeichnet, daß die zweite Ausschalt-Logikschaltung (106) eine Kippstufe (108) umfaßt, deren erster Eingang (H) mit dem Nulldurchgangsmesser (114) verbunden ist, und deren zweiter Eingang (D) entweder mit einem manuell über einen Drucktaster (102) bzw. über einen automatischen Betätigungsmechanismus (104) gegebenen Ausschaltbefehl oder mit dem Ausgangssignal der Schwellwertschaltung (112) beaufschlagt wird.

9. Statische Unterbrechervorrichtung nach einem der Ansprüche 1 bis 8, dadurch gekennzeichnet, daß in Abhängigkeit von der Nennspannung des Mittelspannungsnetzes in jedem Phasenleiter mehrere, mit Thyristoren (18, 20) bestückte Hauptmodule (12, 14...) in Reihe geschaltet werden, wobei sämtliche Module darüber hinaus mit einem Strombegrezungsglied (36), insbesondere einer Schmelzsicherung oder einer Drossel in Reihe geschaltet werden, und daß der Gate-kathoden-kreis jedes Thyristors (18, 20) von der zugehörigen Steuerkreis (26) des Thyristors (18, 20) solange gespeist wird, wie der Durchlaßzustand des betreffenden Thyristors aufrechterhalten bleiben muß.

## Claims

1. A static breaking device, notably a contactor, a switch or a circuit breaker inserted in the line conductors (16R, 16S, 16T) of a three-phase A.C. electrical power supply system with phases (R,S,T), and comprising :
- at least one elementary module arranged in each line conductor (16R, 16S, 16T) and comprising an antiparallel connection of two power thyristors (18, 20), and a voltage chopper device (22) connected in parallel to the terminals of the thyristors (18, 20),
- an individual control circuit (26) associated with the gate of each thyristor (18, 20) to perform switching from the off state to the on state, and vice-versa,
- and a centralised control unit (46) designed to manage the opening and closing control signals (CS1, CS2) sent to the different individual control circuits (26).
characterized in that a polarity indicator (50) cooperates with the module (12, 14) to indicate the direction of the A.C. voltage present at the terminals of the thyristors (18, 20) when the latter are in the off state, and that the centralised control unit (46) comprises :
- a first logic closing circuit (60) sensitive to the information coming from the polarity indicator (50) so as to enable a closing control signal to be sent to the individual control circuit (26) of the thyristor (18, 20) whose anode-cathode voltage becomes negative.
- and a second logic opening circuit (106) controlled by a detector (114) detecting when the line current flowing in the phase preceding the first phase to open in the order of succession of the phases (R, S, T) reaches zero.

2. The static breaking device according to claim 1, characterized in that the polarity indicator (50) is connected in parallel to the terminals of the module (12, 14), and comprises an optoelectronic circuit for discriminating the positive and negative half-waves of the voltage, cooperating with an optic transmission fiber (58) connected to the first logic closing circuit (60) of the centralised control unit (46).

3. The static breaking device according to claim 2, characterized in that the polarity indicator (50) comprises a resistor (52) in series with a head-to-tail assembly of a light-emitting diode (54) and a diode (56).

4. The static breaking device according to claim 2 or 3, characterized in that the first logic closing circuit (60) comprises a converting circuit (64) transforming the light signal transmitted by the optic fiber (58) into an electrical synchronisation signal (SYN) indicating the moment when the voltage is reversed at the terminals of the thyristor (18, 20) to be turned to the on state.

5. The static breaking device according to claim 4, characterized in that the first logic circuit (60) is provided with a flip-flop (62) comprising an input (H) sensitive to the synchronisation signal (SYN) and an output (Q) designed to control sending of the first and second control signals (CS1 and CS2) for closing of the thyristors (18, 20) with a preset time delay.

6. The static breaking device according to claim 1, characterized in that in each line conductor (16R, 16S, 16T) there is inserted a current sensor (48) associated with a threshold circuit (112) connected to the input of the second logic opening circuit (106).

7. The static breaking device according to claim 6, characterized in that each current sensor (48) comprises a non-magnetic toroid designed to insulate the corresponding line conductor (16R, 16S, 16T) from the centralised control unit (46).

8. The static breaking device according to claim 6 or 7, characterized in that the second logic opening circuit (106) comprises a flip-flop (108) having a first input (H) connected to the detector (114), and a second input (D) sensitive either to a manual opening control by a switch (102), or to an automatic opening control by an automatic controller (104) or the threshold circuit (112).

9. The static breaking device according to one of the claims 1 to 8, characterized in that a plurality of elementary modules (12, 14...) with thyristors (18, 20) are placed in series in each line conductor according to the value of the rated voltage of the medium voltage power system, the set of modules being in addition connected in series with a current limiting device (36), notably a fuse cut-out or inductance, and that the individual control circuit (26) of each thyristor (18, 20) continuously supplies the gate-cathode circuit of each thyristor (18, 20) so long as said thyristor remains turned on.
